# EUROPEAN PATENT APPLICATION

(11) **EP 4 832 269 A1**
(43) Date of publication of application: **28.10.2026**
(21) Application number: 25747419.7
(22) Date of filing: 03.01.2025
(51) Int. Cl.: H01S 5/50

(54) **OPTICAL AMPLIFIER AND RELATED DEVICE**

(30) Priority: 30.01.2024 CN 202410138195
(71) Applicant: Huawei Technologies Co., Ltd., Shenzhen, Guangdong 518129 (CN)
(72) Inventor: WANG, Wei, Shenzhen, Guangdong 518129 (CN); GUO, Zhecan, Shenzhen, Guangdong 518129 (CN); CHANG, Zhiwen, Shenzhen, Guangdong 518129 (CN)
(74) Representative: Maiwald GmbH
(86) International application number: PCT/CN2025/070437
(87) International publication number: WO 2025/161843

(57) **Abstract**

Embodiments of this application provide an optical amplifier and a related device, to reduce an NF of the optical amplifier and improve signal transmission quality. The optical amplifier provided in the embodiments of this application includes n gain medium stages sequentially arranged, where the n gain medium stages are configured to sequentially amplify an input optical signal of an optical amplifier, where n≥2. The optical signal is input to a first gain medium stage in the n gain medium stages, and is output from an n^{th} gain medium stage in the n gain medium stages. The n gain medium stages include a first gain medium and a second gain medium, where the first gain medium is an m^{th} gain medium stage in the n gain medium stages, the second gain medium is at least one gain medium subsequent to the first gain medium, where $m \leq \left⌈n/2\right⌉$. The first gain medium and the second gain medium are gain media of different types, and an output end of the first gain medium is connected to an input end of the second gain medium. An average gain of a gain medium type of the first gain medium is greater than an average gain of a gain medium type of the second gain medium.

## Description

This application claims priority to Chinese Patent Application No. CN202410138195.X, filed with the China National Intellectual Property Administration on January 30, 2024 and entitled "OPTICAL AMPLIFIER AND RELATED DEVICE", which is incorporated herein by reference in its entirety.

### TECHNICAL FIELD

Embodiments of this application relate to the field of optical communication, and in particular, to an optical amplifier and a related device.

### BACKGROUND

An optical amplifier (optical amplifier, OA) is a commonly used device in an optical communication network, and is used to amplify power of an optical signal. With the development of the optical communication network, the required power of the optical signal continues to increase, and the gain requirement of the optical amplifier also continues to increase.

A common method for increasing the gain of the optical amplifier is to cascade a plurality of gain media, and amplify an optical signal stage by stage through a plurality of gain medium stages, so as to achieve a high gain of the optical signal.

A gain medium has an inherent noise factor (noise factor, NF). In a structure of a cascaded optical amplifier, an NF of each gain medium stage contributes to an NF of the entire optical amplifier, resulting in a higher NF of the entire optical amplifier. As a result, a signal-to-noise ratio of the optical amplifier is low, affecting signal transmission quality.

### SUMMARY

Embodiments of this application provide an optical amplifier and a related device, to reduce an NF of the optical amplifier and improve signal transmission quality.

According to a first aspect, an embodiment of this application provides an optical amplifier. The optical amplifier includes n gain medium stages sequentially arranged, where the n gain medium stages are configured to sequentially amplify an input optical signal of the optical amplifier, where n≥2. The optical signal is input to a first gain medium stage in the n gain medium stages, and is output from an n^{th} gain medium stage in the n gain medium stages. The n gain medium stages include a first gain medium and a second gain medium, where the first gain medium is an m^{th} gain medium stage in the n gain medium stages, and the second gain medium is at least one gain medium subsequent to the first gain medium, where $m \leq \left⌈n/2\right⌉$. That is, m is less than or equal to a result of ceiling (n/2). The first gain medium and the second gain medium are gain media of different types. An output end of the first gain medium is connected to an input end of the second gain medium. An average gain of a gain medium type of the first gain medium is greater than an average gain of a gain medium type of the second gain medium. In this embodiment of this application, the average gain is an average of gains of a gain medium for signals in an operating band.

In this embodiment of this application, in a structure of an optical amplifier with a plurality of gain medium stages, NFs of the first half of the gain medium stages contribute significantly to an overall NF of the optical amplifier, and an NF of a gain medium is negatively correlated with an average gain of a type of the gain medium. Therefore, making the average gain (of the gain medium type, hereinafter referred to as the type) of the first gain medium in first $m \leq \left⌈n/2\right⌉$ stages greater than the average gain (of the type) of the subsequent second gain medium can minimize the NF of the optical amplifier, improve a signal-to-noise ratio of the optical amplifier, and improve the signal transmission quality.

In an optional implementation, a maximum average gain of the gain medium type of the first gain medium is greater than a maximum average gain of the gain medium type of the second gain medium.

In this embodiment of this application, the maximum average gain is an average of gains of a gain medium at an optimal medium length for signals at various wavelengths in an operating band (which is an operating band of the optical amplifier), and the optimal medium length is a medium length corresponding to a maximum gain at different medium lengths.

In this embodiment of this application, a maximum average gain of a type of a gain medium is a representation of an average gain of the type of the gain medium. Compared with the average gain, the maximum average gain can more accurately reflect the type of the gain medium, so that the first gain medium and the second gain medium are more accurately distinguished.

It should be noted that, in other implementations below, gain media of different types can also be better distinguished by using the maximum average gain, which is not repeated below.

In an optional implementation, m≥2, and the n gain medium stages sequentially arranged include the first gain medium stage to the m^{th} gain medium stage that are connected stage by stage. In the first gain medium stage to the m^{th} gain medium stage that are connected stage by stage, an average gain of a type of each gain medium stage is greater than an average gain of the type of the second gain medium.

In this embodiment of this application, average gains (of the types) of the first m gain medium stages are greater than the average gain (of the type) of a subsequent second gain medium, so that it can be ensured that NFs of first gain medium stages are small. Because a weight of the first m gain medium stages is greater than a weight of the subsequent second gain medium, the structure may make the NF of the gain medium with a larger weight relatively small, thereby reducing the noise factor *NFₒₐ* of the optical amplifier and improving the signal transmission quality.

It should be noted that, the first gain medium stage to the m^{th} gain medium stage that are connected stage by stage may be gain media of the same type, or may be gain media of different types, which is not limited in this application.

In an optional implementation, m≤n/3.

In this embodiment of this application, because the first third of the gain media are gain media near the front of the n gain medium stages, a weight of a noise factor *NFₒₐ* of the first third of the gain media is relatively large. The first gain medium is limited to the first third of the gain media, so that the noise factor *NFₒₐ* can be more significantly reduced, and the signal transmission quality can be improved.

In an optional implementation, m=1. If a quantity of second gain media is 1, the output end of the first gain medium is connected to the input end of the second gain medium; or if a quantity of second gain media is greater than 1, the output end of the first gain medium is connected to an input end of a foremost gain medium of the plurality of second gain media.

In this embodiment of this application, because a weight of a noise factor *NFₒₐ* of the first gain medium stage is the largest in the n gain medium stages, the first gain medium is limited as the first gain medium stage. Compared with that the first gain medium is arranged at another position, this can achieve an optimal optimization effect on the noise factor *NFₒₐ* , thereby improving the signal transmission quality.

In an optional implementation, in the n gain medium stages sequentially arranged, an average gain of a type of any gain medium is greater than an average gain of a type of a subsequent gain medium stage. That is, in n gain medium stages 2000, from a first gain medium stage to an n^{th} gain medium stage, average gains of types of the gain media decrease stage by stage.

In this embodiment of this application, because the average gain of the gain medium is negatively correlated with the NF, the average gains of the n gain medium stages decrease stage by stage, so that the NFs of the n gain medium stages increase stage by stage. The weights of the n gain medium stages decrease stage by stage (a gain medium that is nearer the front has a larger weight of the noise factor *NFₒₐ)*. In the n gain medium stages, the weights of the gain medium stages decrease stage by stage, and the NFs increase stage by stage, so that a gain medium with a larger weight has a smaller NF, thereby better reducing the noise factor *NFₒₐ* and improving the signal transmission quality.

In an optional implementation, m≥2, and the n gain medium stages further include a third gain medium, where the third gain medium is a k^{th} gain medium stage in the n gain medium stages, and k<m. The third gain medium and the first gain medium are gain media of different types. An average gain of a gain medium type of the third gain medium is less than the average gain of the gain medium type of the first gain medium.

In an optional implementation, m=2, and k=1.

In an optional implementation, the n gain medium stages further include a fourth gain medium, an input end of the fourth gain medium is connected to an output end of the second gain medium, and the fourth gain medium and the second gain medium are gain media of different types. An average gain of a gain medium type of the fourth gain medium is greater than the average gain of the gain medium type of the second gain medium.

In an optional implementation, at least one target gain medium exists in the second gain medium, and gain flatness of the target gain medium is better than gain flatness of the first gain medium. The target gain medium is at least one gain medium subsequent to the m^{th} gain medium stage.

In the same gain medium stage, an average gain and gain flatness cannot be optimal at the same time. During application, a trade-off needs to be made between the average gain and the gain flatness. Because the target gain medium is near the back of the n gain medium stages, the weight of the target gain medium is small. Attempting to reduce the noise factor *NFₒₐ* of the optical amplifier oa by increasing the average gain of the target gain medium yields only a small benefit and is of little significance. Therefore, making the gain flatness of the target gain medium better (than gain flatness of a first gain medium 2100) can improve spectral flatness of the optical amplifier oa, thereby reducing a GFF depth, reducing a loss of the optical amplifier oa, and further reducing pump power of a pump module corresponding to each gain medium stage.

In an optional implementation, gain flatness of a gain medium in the at least one second gain medium is better than the gain flatness of the first gain medium.

In this embodiment of this application, the first gain medium is mainly configured to reduce the noise factor *NFₒₐ* of the optical amplifier oa. The second gain medium subsequent to the first gain medium has a little impact on the noise factor *NFₒₐ* of the optical amplifier oa. Therefore, gain flatness of all the second gain media subsequent to the first gain medium is better than the gain flatness of the first gain medium. In this way, the gain flatness of the optical amplifier oa is improved through all the second gain media, thereby more significantly reducing the GFF depth, reducing the loss of the optical amplifier oa, and reducing the pump power.

In an optional implementation, in the n gain medium stages sequentially arranged, gain flatness of any gain medium is better than gain flatness of a preceding gain medium stage.

In this embodiment of this application, because the average gain and the gain flatness of the gain medium cannot be optimal at the same time, improving the gain flatness of the n gain medium stages stage by stage can achieve that in a trade-off between the average gain and the gain flatness, a gain medium that is nearer the front is biased more toward the average gain, and a gain medium that is nearer the back is biased more toward the gain flatness. According to the foregoing descriptions of the weight of the noise factor *NFₒₐ* of each gain medium stage, it can be learned that the weights of the n gain medium stages decrease stage by stage (where a gain medium that is nearer the front has a larger weight of the noise factor *NFₒₐ*). As the gain medium that is nearer the front is biased more toward the average gain, the noise factor *NFₒₐ* of the optical amplifier oa can be better reduced; and as the gain medium that is nearer the back is biased more toward the gain flatness, the loss of the optical amplifier oa can be better reduced. In this case, the optical amplifier oa has both a low noise factor *NFₒₐ* and a low loss.

In an optional implementation, the n gain medium stages sequentially arranged include a plurality of gain media of different types.

In an optional implementation, a plurality of second gain media are provided, and the plurality of second gain media include a plurality of gain media of different types.

In an optional implementation, the plurality of gain media of different types include at least one of the following: doped fibers with different doping elements, doped fibers with different doping concentrations, and gain media with different structures.

In an optional implementation, a gain flattening filter GFF and/or a variable optical attenuator VOA are/is further included between the output end of the first gain medium and the input end of the second gain medium, where the GFF is configured to balance gains of optical signals at various wavelengths, and the VOA is configured to adjust a gain point and a tilt of the optical amplifier.

In an optional implementation, the optical amplifier further includes a control circuit. The control circuit is configured to control at least one of the following of an output optical signal of the optical amplifier: output optical power, a gain, and a tilt.

According to a second aspect, an embodiment of this application provides an optical communication device. The optical communication device includes the optical amplifier according to the first aspect.

### BRIEF DESCRIPTION OF DRAWINGS

FIG. 1 is a diagram of a structure of an optical communication system according to this application;
FIG. 2 is a diagram of a structure of an optical amplifier oa according to an embodiment of this application;
FIG. 3 is a diagram of gains of a gain medium at different medium lengths according to an embodiment of this application;
FIG. 4 is a diagram of a structure of an optical amplifier oa in which maximum average gains decrease stage by stage according to an embodiment of this application;
FIG. 5a is a diagram of a structure of an optical amplifier oa in which a low-gain medium is included in a stage preceding a first gain medium according to an embodiment of this application;
FIG. 5b is another diagram of a structure of an optical amplifier oa in which a low-gain medium is included in a stage preceding a first gain medium according to an embodiment of this application;
FIG. 6 is a diagram of a structure of an optical amplifier oa including a third gain medium according to an embodiment of this application;
FIG. 7 is a diagram of a structure of an optical amplifier oa including a fourth gain medium according to an embodiment of this application;
FIG. 8 is a diagram of an arrangement of gain flatness of an optical amplifier oa according to an embodiment of this application;
FIG. 9 is a diagram of a wavelength-gain curve according to an embodiment of this application; and
FIG. 10 is a diagram of a structure of an optical amplifier oa including second gain media of different types according to an embodiment of this application.

### DESCRIPTION OF EMBODIMENTS

The following describes embodiments of this application with reference to the accompanying drawings. A person of ordinary skill in the art may learn that, with development of technologies and emergence of a new scenario, the technical solutions provided in embodiments of this application are also applicable to a similar technical problem.

In the specification, claims, and accompanying drawings of this application, the terms "first", "second", and so on are intended to distinguish between similar objects but do not necessarily indicate a specific order or sequence. It should be understood that the terms used in such a way are interchangeable in proper circumstances, which is merely a discrimination manner that is used when objects having a same attribute are described in embodiments of this application. In addition, the terms "include", "have" and any other variants are intended to cover the non-exclusive inclusion, so that a process, method, system, product, or device that includes a series of units is not necessarily limited to those units, but may include other units not expressly listed or inherent to such a process, method, product, or device. In addition, "at least one" means one or more, and "a plurality of" means two or more. The term "and/or" describes an association relationship between associated objects, and represents that three relationships may exist. For example, A and/or B may represent the following cases: Only A exists, both A and B exist, and only B exists, where A and B may be singular or plural. The character "/" generally indicates an "or" relationship between the associated objects. "At least one of the following items (pieces)" or a similar expression thereof indicates any combination of these items, including a single item (piece) or any combination of a plurality of items (pieces). For example, at least one item (piece) of a, b, or c may indicate: a, b, c, a and b, a and c, b and c, or a, b, and c, where a, b, and c may be singular or plural.

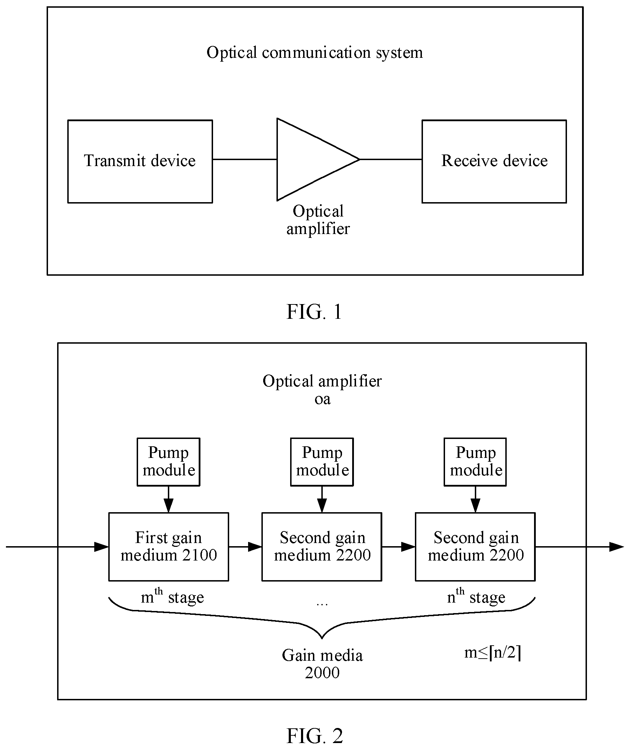

FIG. 1 is a diagram of a structure of an optical communication system. The optical communication system includes a transmit device, a receive device, and a fiber. The transmit device is configured to perform electro-optic modulation, to carry a signal in an optical signal and input the optical signal into the fiber for transmission. The fiber is configured to transmit the optical signal. The receive device is configured to receive and parse the optical signal.

As shown in FIG. 1, the optical communication system may further include an optical amplifier. The optical amplifier is located between the transmit device and the receive device. The optical amplifier is configured to implement relay and amplification of an optical signal, to increase power of the optical signal at the receive device. In this way, a signal loss is compensated, and signal transmission reliability and transmission quality are improved.

Optionally, the optical amplifier can also exist in any optical communication device (for example, a transmit device, a receive device, or a relay node) in an optical communication system, and is configured to amplify an optical signal.

With the development of optical communication technologies, the transmission power requirement of an optical communication system continues to increase, and the output power requirement of an optical amplifier also continues to increase. To increase the output power of the optical amplifier, a gain of the optical amplifier needs to be increased. A common method is to cascade a plurality of gain media in an optical amplifier, and amplify an optical signal stage by stage through a plurality of gain medium stages, so as to achieve a high gain of the optical signal, thereby improving the output power of the optical amplifier.

However, the gain medium has an inherent noise factor NF. In a structure of an optical amplifier with a plurality of gain medium stages, an NF of each gain medium stage contributes to an NF of the optical amplifier, resulting in a higher NF of the optical amplifier. The higher NF leads to a lower optical signal-to-noise ratio (optical signal-to-noise ratio, OSNR) of the optical amplifier, affecting the signal transmission quality.

To resolve the foregoing problem, embodiments of this application provide an optical amplifier and a related device. According to the optical amplifier provided in embodiments of this application, a gain medium with a high average gain in a plurality of gain medium stages is arranged at a position near the front, so as to reduce the NF of the optical amplifier, thereby improving the signal transmission quality.

The optical amplifier oa provided in embodiments of this application includes n gain medium stages 2000 sequentially arranged, and a theoretical calculation formula of a noise factor *NFₒₐ* of the optical amplifier oa is shown in Formula 1 below: ${NF}_{oa} = {NF}_{1} + \frac{{L}_{2} \times {NF}_{2} - 1}{{G}_{1}} + \frac{{L}_{2} \times {L}_{3} \times {NF}_{3} - 1}{{G}_{1} \times {G}_{2}} + ⋯$ (Formula 1)

*NFₓ* is a noise factor of an x^{th} gain medium stage; *Gₓ* is a gain of the x^{th} gain medium stage, and is an actual gain of a gain medium; and *Lₓ* is a loss value between an (x-1)^{th} gain medium stage and the x^{th} gain medium stage.

n terms included in Formula 1 are noise factors respectively generated by the n gain medium stages, and a sum of the n terms is the noise factor *NFₒₐ* of the optical amplifier oa. If a noise factor generated by each gain medium stage in the optical amplifier oa in Formula 1 is divided by a noise factor *NFₓ* of the gain medium stage, a weight of the gain medium stage in the optical amplifier oa can be obtained. A larger weight indicates a greater contribution of the gain medium stage to the noise factor *NFₓ* of the optical amplifier oa. Compared with *Lₓ*, *Gₓ* is usually greater. Therefore, an impact of *Gₓ* on the weight is mainly considered.

In Formula 1, a noise factor generated by a first gain medium stage is a first term *NF*₁, and a ratio of *NF*₁ to the noise factor *NF*₁ of the first gain medium stage is 1, that is, a weight of the first gain medium stage is 1.

In Formula 1, a noise factor generated by a second gain medium stage is a second term $\frac{{L}_{2} \times {NF}_{2} - 1}{{G}_{1}}$, and a ratio of $\frac{{L}_{2} \times {NF}_{2} - 1}{{G}_{1}}$ to the noise factor *NF*₂ of the second gain medium stage is about $\frac{{L}_{2}}{{G}_{1}}$, that is, a weight of the second gain medium stage is $\frac{{L}_{2}}{{G}_{1}}$. The weight $\frac{{L}_{2}}{{G}_{1}}$ of the second gain medium stage is less than the weight 1 of the first gain medium stage.

In Formula 1, a noise factor generated by a third gain medium stage is a third term $\frac{{L}_{2} \times {L}_{3} \times {NF}_{3} - 1}{{G}_{1} \times {G}_{2}}$, and a ratio of $\frac{{L}_{2} \times {L}_{3} \times {NF}_{3} - 1}{{G}_{1} \times {G}_{2}}$ to the noise factor *NF*₃ of the third gain medium stage is about $\frac{{L}_{2} \times {L}_{3}}{{G}_{1} \times {G}_{2}}$, that is, a weight of the third gain medium stage is $\frac{{L}_{2} \times {L}_{3}}{{G}_{1} \times {G}_{2}}$. The weight $\frac{{L}_{2} \times {L}_{3}}{{G}_{1} \times {G}_{2}}$ of the third gain medium stage is less than the weight $\frac{{L}_{2}}{{G}_{1}}$ of the second gain medium stage.

By analogy, it can be learned that a weight of a gain medium becomes smaller when the gain medium is nearer the back. In other words, noise factors *NF* of first several gain medium stages in the optical amplifier oa have a great impact on the optical amplifier oa. In addition, a noise factor *NF* of a gain medium that is nearer the front has a greater impact on the optical amplifier oa. The noise factor *NFₒₐ* of the optical amplifier oa can be reduced provided that the noise factors NFs of the first several gain medium stages are reduced.

Therefore, in embodiments of this application, an idea of reducing the noise factor *NFₒₐ* of the optical amplifier oa is: making the noise factors of the first several gain medium stages in the n gain medium stages less than noise factors NFs of last several gain medium stages in the n gain medium stages. Because a noise factor NF of a gain medium is negatively correlated with an average gain of a type of the gain medium (hereinafter referred to as an average gain of the gain medium for ease of description), making average gains of the first several gain medium stages in the optical amplifier oa greater than average gains of the last several gain medium stages can reduce the NFs of the first several gain medium stages, thereby reducing the noise factor *NFₒₐ* of the optical amplifier oa.

Therefore, an embodiment of this application provides a structure of an optical amplifier shown in FIG. 2. In the structure, an average gain of an m^{th} gain medium stage (a first gain medium 2100) that is near the front of the optical amplifier oa is greater than an average gain of a second gain medium 2200 subsequent to the first gain medium 2100, so that an NF of the m^{th} gain medium stage that is near the front is reduced, thereby reducing a noise factor *NFₒₐ* of the optical amplifier oa.

As shown in FIG. 2, the optical amplifier (optical amplifier, oa) provided in this embodiment of this application includes n gain medium stages 2000 sequentially arranged, where n≥2. An optical signal is input to a first gain medium stage in the n gain medium stages 2000, and is output from an n^{th} gain medium stage in the n gain medium stages 2000. The n gain medium stages 2000 are configured to sequentially amplify an input optical signal of the optical amplifier oa.

The n gain medium stages 2000 include a first gain medium 2100 and a second gain medium 2200. The first gain medium 2100 and the second gain medium 2200 are gain media of different types. An average gain of a gain medium type of the first gain medium 2100 is greater than an average gain of a gain medium type of the second gain medium 2200. For example, the first gain medium 2100 is a semiconductor optical amplifier (semiconductor optical amplifier, SOA), and the second gain medium 2200 is an erbium-doped fiber (erbium-doped fiber, EDF).

The first gain medium 2100 is the m^{th} gain medium stage in the n gain medium stages 2000, the second gain medium 2200 is at least one gain medium subsequent to the first gain medium 2100. An output end of the first gain medium 2100 is connected to an input end of the second gain medium 2200.

In this embodiment of this application, the first gain medium 2100 is the m^{th} gain medium stage that is near the front of the n gain medium stages 2000. In the n gain medium stages 2000, when the first gain medium 2100 is nearer the front (that is, m is smaller), the noise factor *NFₒₐ* of the optical amplifier oa is smaller, so that the signal transmission quality is better.

To achieve a small noise factor *NFₒₐ*, a value range of m may be limited to $m \leq \left⌈n/2\right⌉$. That is, m is less than or equal to a result of ceiling (n/2), so that the first gain medium 2100 is limited within the first half of the n gain medium stages 2000.

That is, in the n gain medium stages 2000, the first gain medium 2100 exists in the first half of the gain medium stages. At least one second gain medium 2200 exists subsequent to the first gain medium 2100, and the average gain of the type of the second gain medium 2200 is less than the average gain of the type of the first gain medium 2100.

For example, in FIG. 2, if n=3, $m \leq \left⌈3/2\right⌉ = 2$, and m may be 1 or 2. In this case, the first gain medium 2100 is a first or second gain medium stage in three gain medium stages 2000. In FIG. 2, the first gain medium stage is used as an example of the first gain medium 2100, and the second gain medium stage and a third gain medium stage are second gain media 2200.

In this embodiment of this application, an average gain is an inherent characteristic of a gain medium, and is related to a type of the gain medium. An average of gains of the gain medium for signals at various wavelengths in an operating band of the optical amplifier oa is an average gain of such a type of the gain medium.

It should be noted that the average gain of the type of the gain medium is an inherent attribute of the medium type. However, in the optical amplifier oa, an actual gain of the first gain medium 2100 may be greater or less than an actual gain of the second gain medium 2200, which is not limited in this application. In an example, the gain of the first gain medium 2100 is 3 dB, and the gain of the second gain medium 2200 is 4 dB.

In this embodiment of this application, in a structure of an optical amplifier with a plurality of gain medium stages, NFs of the first half of the gain medium stages contribute significantly to an overall NF of the optical amplifier, and an NF of a gain medium is negatively correlated with an average gain of a type of the gain medium. Therefore, making the average gain (of the gain medium type, hereinafter referred to as the type) of the first gain medium 2100 at the m^{th} stage that is near the front of the n gain medium stages 2000 greater than the average gain of (the type of) the subsequent second gain medium in the n gain medium stages 2000 can minimize the NF of the optical amplifier, improve a signal-to-noise ratio of the optical amplifier, and improve the signal transmission quality.

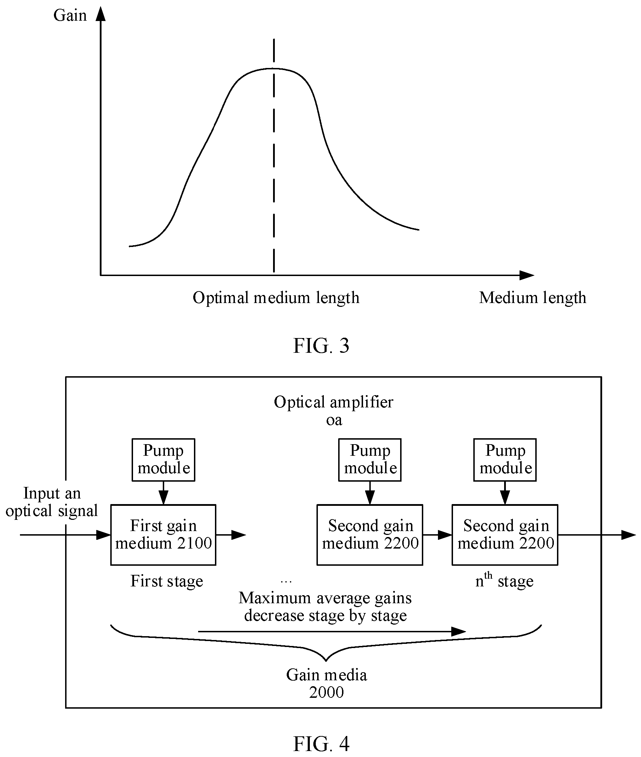

A maximum average gain of a type of a gain medium is a representation of an average gain of the type of the gain medium. The maximum average gain is also an inherent characteristic of the gain medium, and is related to the type of the gain medium. For each type of gain medium, a gain of the gain medium is correlated to a medium length, and an example of a corresponding medium length-gain curve is shown in FIG. 3. In the medium length-gain curve, a medium length corresponding to a maximum gain value is an optimal medium length of the type of gain medium. An average of gains of the type of gain medium at the optimal medium length for signals at various wavelengths in an operating band of the optical amplifier oa is a maximum average gain of the type of gain medium.

In an optional implementation, a maximum average gain of the gain medium type of the first gain medium 2100 may be greater than a maximum average gain of the gain medium type of the second gain medium 2200.

In this embodiment of this application, a maximum average gain of a type of a gain medium is a representation of an average gain of the type of the gain medium. Compared with the average gain, the maximum average gain can more accurately reflect the type of the gain medium, so that the first gain medium and the second gain medium are more accurately distinguished.

It should be noted that, in other embodiments below, gain media of different types can also be better distinguished by using the maximum average gain, which is not repeated below.

In this embodiment of this application, the optical amplifier oa may further include a pump module of each gain medium stage 2000. The pump module is configured to output a pump to a corresponding gain medium. For example, in FIG. 2, the first gain medium stage is an erbium-doped fiber, so that a pump module of the gain medium stage is configured to emit pump light, and the pump light is output to the first gain medium stage, so as to amplify an optical signal. Optionally, the pump may be pump light, a pump current, a pump voltage, or the like. This is not limited in this application.

Optionally, the value range of m may be further narrowed down, so that the first gain medium 2100 is nearer the front, thereby further reducing the noise factor *NFₒₐ* of the optical amplifier oa and improving the signal transmission quality. For example, the value range of m may be limited to m≤n/3, so that the first gain medium 2100 is limited within the first third of the n gain medium stages 2000.

In this embodiment of this application, because the first third of the gain media are gain media near the front of the n gain medium stages 2000, a weight of a noise factor *NFₒₐ* of the first third of the gain media is relatively large. The first gain medium 2100 is limited to the first third of the gain media, so that the noise factor *NFₒₐ* can be more significantly reduced, and the signal transmission quality can be improved.

In an optional implementation, m=1, that is, the first gain medium 2100 is the first gain medium stage in the n gain medium stages 2000. In this embodiment of this application, because a weight of a noise factor *NFₒₐ* of the first gain medium stage is the largest in the n gain medium stages 2000, the first gain medium 2100 is limited as the first gain medium stage. Compared with that the first gain medium 2100 is arranged at another position, this can achieve an optimal optimization effect on the noise factor *NFₒₐ*, thereby improving the signal transmission quality.

In an optional implementation, in the n gain medium stages 2000 sequentially arranged, an average gain of a type of any gain medium is greater than an average gain of a type of a subsequent gain medium stage. That is, as shown in FIG. 4, in the n gain medium stages 2000, from the first gain medium stage to the n^{th} gain medium stage, the maximum average gains of the gain media decrease stage by stage. The first gain medium stage with the largest maximum average gain value is a first gain medium 2100, and other gain media than the first gain medium stage are second gain media 2200.

In this embodiment of this application, because the average gain of the type of the gain medium is negatively correlated with the NF, the average gains of the n gain medium stages 2000 decrease stage by stage, so that NFs of the n gain medium stages 2000 increase stage by stage. According to the foregoing descriptions of the weight of the noise factor *NFₒₐ* of each gain medium stage, it can be learned that weights of the n gain medium stages 2000 decrease stage by stage (where a gain medium that is nearer the front has a larger weight of the noise factor *NFₒₐ*). In the n gain medium stages 2000, the weights of the gain medium stages decrease stage by stage, and the NFs increase stage by stage, so that a gain medium with a larger weight has a smaller NF, thereby better reducing the noise factor *NFₒₐ* and improving the signal transmission quality.

Similarly, in a plurality of second gain media 2200 sequentially arranged, a maximum average gain of any gain medium may be greater than a maximum average gain of a subsequent gain medium stage. That is, maximum average gains of the plurality of second gain media 2200 subsequent to the first gain medium 2100 decrease stage by stage.

Similarly, in the n gain medium stages 2000 sequentially arranged, a maximum average gain of a type of any gain medium may be greater than a maximum average gain of a type of a subsequent gain medium stage.

In an optional implementation, m≥2. To reduce the noise factor *NFₒₐ* as much as possible, maximum average gain values of first several gain medium stages may be large. A specific solution is that, in the n gain medium stages 2000, average gains of types of a first gain medium stage to an m^{th} gain medium stage are greater than an average gain of a type of a second gain medium.

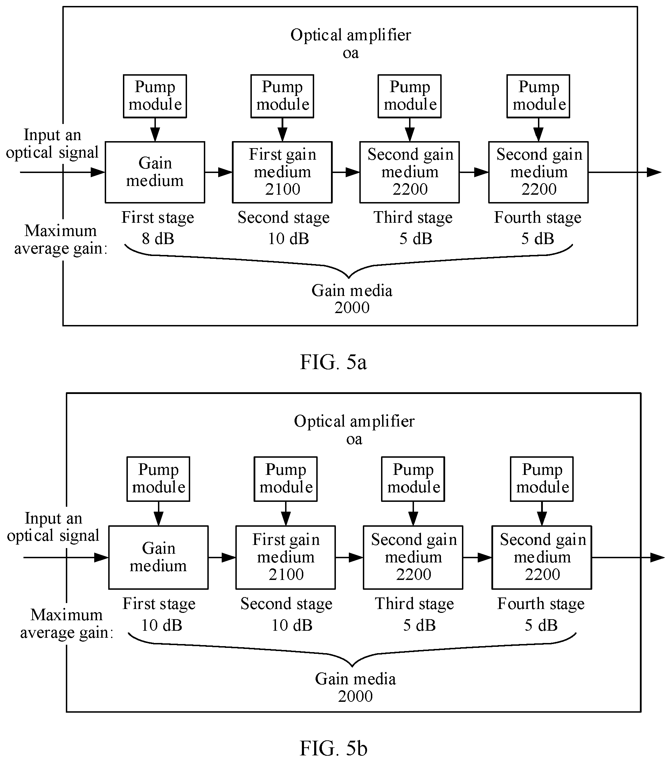

For example, as shown in FIG. 5a, n=4, m=2, and the first gain medium 2100 is a second gain medium stage, and therefore, a third gain medium stage and a fourth gain medium stage are both second gain media 2200.

The average gain of the first gain medium stage is 8 dB, and the average gain of the second gain medium stage (the first gain medium 2100) is 10 dB, both of which are greater than the average gain, which is 5 dB, of the second gain medium 2200 (the third or fourth gain medium stage).

In this embodiment of this application, the average gains of the first m gain medium stages are greater than the average gain of the subsequent second gain medium 2200, so that it can be ensured that NFs of the first gain medium stages are small. Because a weight of the first m gain medium stages is greater than a weight of the subsequent second gain medium 2200, the structure may make an NF of a gain medium with a larger weight relatively small, thereby reducing the noise factor *NFₒₐ* and improving the signal transmission quality.

It should be noted that, the first m gain medium stages may be shown in FIG. 5a, and are gain media of different types, so that the average gains of the types of the first m gain medium stages are different. Alternatively, as shown in FIG. 5b, the first m gain medium stages may be gain media of a same type (for example, are all erbium-doped fibers), and the average gains of the first m gain medium stages are the same. This is not limited in this application.

Similarly, maximum average gains of the first m gain medium stages may alternatively be greater than a maximum average gain of the subsequent second gain medium 2200.

In an optional implementation, a third gain medium 2300 with a lower gain is further included in a stage preceding the first gain medium 2100.

The third gain medium 2300 is a k^{th} gain medium stage in the n gain medium stages, where k<m. The third gain medium 2300 and the first gain medium 2100 are gain media of different types. An output end of the third gain medium 2300 is connected to an input end of the first gain medium 2100. An average gain of a gain medium type of the third gain medium 2300 is less than the average gain of the gain medium type of the first gain medium 2100.

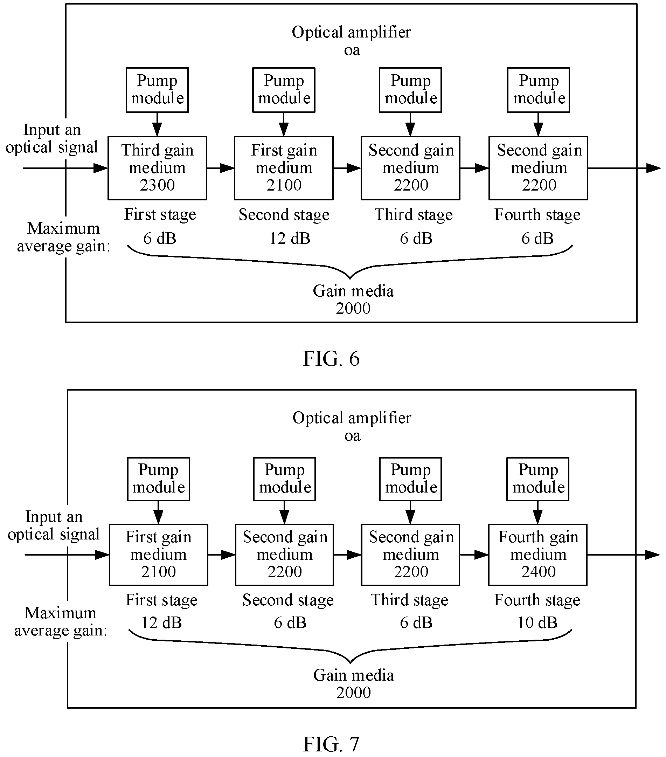

For example, as shown in FIG. 6, n=4, m=2, and the first gain medium 2100 is the second gain medium stage, with an average gain of 12 dB. The third gain medium stage and the fourth gain medium stage are both the second gain media 2200, with an average gain of 6 dB. The first gain medium stage is the third gain medium 2300, with an average gain of 6 dB, which is less than the average gain of the first gain medium 2100.

In an optional implementation, a fourth gain medium 2400 with a higher gain is further included subsequent to the second gain medium 2200. An input end of the fourth gain medium 2400 is connected to an output end of the second gain medium 2200, and the fourth gain medium 2400 and the second gain medium 2200 are gain media of different types. An average gain of a gain medium type of the fourth gain medium is greater than the average gain of the gain medium type of the second gain medium.

For example, as shown in FIG. 7, n=4, m=1, and the second and third gain medium stages are second gain media 2200, with a maximum average gain of 6 dB. The fourth gain medium stage is the fourth gain medium 2400, with an average gain of 10 dB, which is greater than the average gain of the second gain medium 2200.

In this embodiment of this application, in addition to reducing the noise factor *NFₒₐ* of the optical amplifier oa, a gain flattening filter (gain flattening filter, GFF) depth of the optical amplifier oa may be reduced by sorting gain flatness of all gain medium stages in the n gain medium stages 2000, thereby reducing power consumption of the optical amplifier oa.

In an optional implementation, a target gain medium exists in at least one second gain medium 2200 subsequent to the first gain medium 2100, and gain flatness of the target gain medium is better than the gain flatness of the first gain medium 2100.

In this embodiment of this application, the optical amplifier oa may further include components such as a gain flattening filter GFF and a variable optical attenuator (variable optical attenuator, VOA). The GFF may be located between any two gain medium stages in the n gain medium stages 2000, and is configured to balance gains of optical signals at various wavelengths. The VOA may be located between any two gain medium stages in the n gain medium stages 2000, and is configured to adjust a gain point and a tilt of the optical amplifier oa.

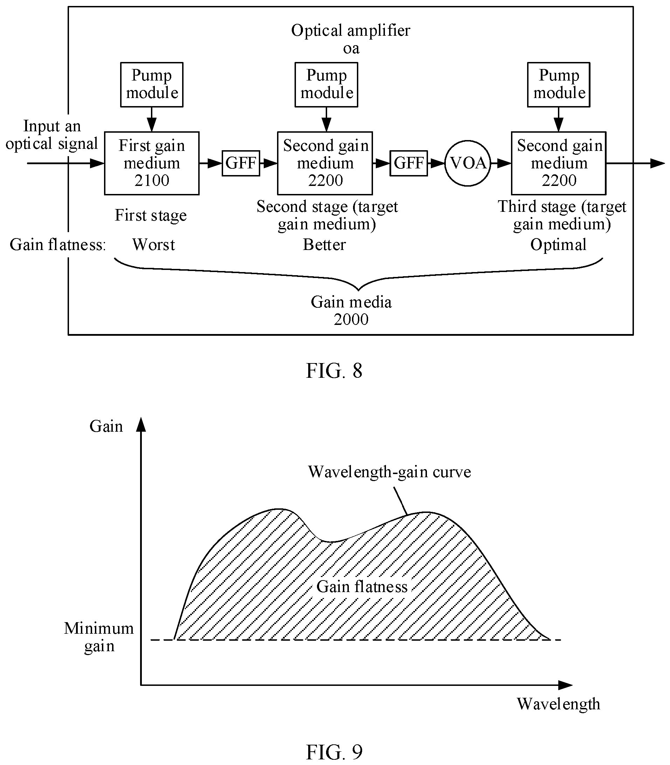

For example, as shown in FIG. 8, n=3, one GFF is included between the first gain medium stage (the first gain medium 2100) and the second gain medium stage, and one GFF and one VOA are included between the second gain medium stage and the third gain medium stage.

After amplifying the input optical signal, the first gain medium stage outputs the amplified optical signal to the GFF, and the GFF performs flattening filtering on the signal, so that a gain spectrum of the signal is flatter. Then, the optical signal is sequentially input to the second gain medium stage for amplification, input to the GFF for flattening filtering, input to the VOA for adjusting attenuation to cooperate with power adjustment of the pump module (to implement locking of different gain points and adjustment of the tilt of the optical amplifier), and input to the third gain medium stage for amplification.

As shown in FIG. 9, after the optical signal is amplified by the gain media, the gains at various wavelengths are different due to the gain flatness of the gain media. The gains in some bands are large, and the gains in some bands are small. According to a wavelength-gain curve shown in FIG. 9, the average gains at various wavelengths in an operating band of the optical amplifier oa may be obtained. An envelope area between a minimum gain of the operating band and the wavelength-gain curve is calculated, to obtain the gain flatness.

The GFF implements flattening filtering of signals by weakening a peak in the curve. The GFF is a filter for attenuating an optical signal. A greater GFF depth indicates higher power of attenuation by the GFF. Poorer gain flatness of the gain medium corresponds to a greater GFF depth, higher power of attenuation by the GFF indicates a larger loss on the optical amplifier oa. Therefore, the pump module needs to provide a pump with higher power.

In the same gain medium stage, a maximum average gain and gain flatness cannot be optimal at the same time. During application, a trade-off needs to be made between the average gain and the gain flatness. Because the target gain medium is near the back of the n gain medium stages, the weight of the target gain medium is small. Attempting to reduce the noise factor *NFₒₐ* of the optical amplifier oa by increasing the maximum average gain of the target gain medium yields only a small benefit and is of little significance. Therefore, making the gain flatness of the target gain medium better (than gain flatness of a first gain medium 2100) can improve spectral flatness of the optical amplifier oa, thereby reducing a GFF depth, reducing a loss of the optical amplifier oa, and further reducing pump power of a pump module corresponding to each gain medium stage.

In an optional implementation, gain flatness of any gain medium in the at least one second gain medium 2200 is better than the gain flatness of the first gain medium 2100. For example, as shown in FIG. 8, the first gain medium stage is the first gain medium 2100, and the second and third gain medium stages are second gain media 2200 and are target gain media. The gain flatness of the second gain medium stage and the gain flatness of the third gain medium stage are both better than the gain flatness of the first gain medium stage.

In this embodiment of this application, the first gain medium 2100 is mainly configured to reduce the noise factor *NFₒₐ* of the optical amplifier oa. The second gain medium subsequent to the first gain medium 2100 has a little impact on the noise factor *NFₒₐ* of the optical amplifier oa. Therefore, gain flatness of all the second gain media 2200 subsequent to the first gain medium 2100 is better than the gain flatness of the first gain medium 2100. In this way, the gain flatness of the optical amplifier oa is improved through all the second gain media 2200, thereby more significantly reducing the GFF depth, reducing the loss of the optical amplifier oa, and reducing the pump power.

In an optional implementation, in the n gain medium stages 2000 sequentially arranged, gain flatness of any gain medium is better than gain flatness of a preceding gain medium stage. That is, the gain flatness of the n gain medium stages 2000 is improved stage by stage, as shown in FIG. 8.

In this embodiment of this application, because the maximum average gain and the gain flatness of the gain medium cannot be optimal at the same time, improving the gain flatness of the n gain medium stages 2000 stage by stage can achieve the effect that in a trade-off between the maximum average gain and the gain flatness, a gain medium that is nearer the front is biased more toward the maximum average gain, while a gain medium that is nearer the back is biased more toward the gain flatness. According to the foregoing descriptions of the weight of the noise factor *NFₒₐ* of each gain medium stage, it can be learned that the weights of the n gain medium stages 2000 decrease stage by stage (where a gain medium that is nearer the front has a larger weight of the noise factor *NFₒₐ*). As the gain medium that is nearer the front is biased more toward the maximum average gain, the noise factor *NFₒₐ* of the optical amplifier oa can be better reduced; and as the gain medium that is nearer the back is biased more toward the gain flatness, the loss of the optical amplifier oa can be better reduced. In this case, the optical amplifier oa has both a low noise factor *NFₒₐ* and a low loss.

It should be noted that FIG. 8 is merely an example of positions of GFFs and VOAs, and does not limit a quantity of GFFs and a quantity and positions of VOAs. The optical amplifier oa may include more or fewer GFFs and more or fewer VOAs. This is not limited in this application.

In any embodiment of FIG. 2 to FIG. 7, a GFF and/or a VOA may also be included. This is not limited in this application.

In this embodiment of this application, a type of each gain medium stage in the n gain medium stages 2000 sequentially arranged is not limited. The n gain medium stages 2000 may be gain media of different types. This is not limited in this application.

In this embodiment of this application, gain media of different types may include doped fibers with different doping elements, doped fibers with different doping concentrations, or gain media with different structures. This is not limited in this application.

Using FIG. 2 as an example, if the first gain medium stage is an erbium-doped fiber, and the second gain medium stage is a bismuth-doped fiber, the first gain medium stage and the second gain medium stage are doped fibers with different doping elements. If the first gain medium stage is a semiconductor optical amplifier (semiconductor optical amplifier, SOA), and an n^{th} gain medium stage is an erbium-doped fiber, the first gain medium stage and the n^{th} gain medium stage are gain media with different structures. Optionally, optical fibers with different core diameters and different refractive indexes are also gain media with different structures. This is not limited in this application.

In an optional implementation, a plurality of second gain media 2200 are provided, and the plurality of second gain media 2200 may alternatively include a plurality of gain media of different types.

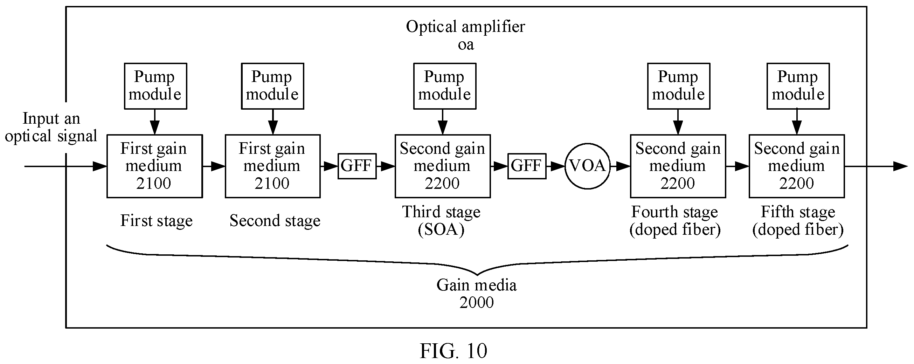

For example, as shown in FIG. 10, n=5, m=2, and k=3. In the five gain medium stages 2000, the first and second gain medium stages are the first gain media 2100, and the third to fifth gain medium stages are the second gain media 2200. The third gain medium stage is an SOA, and the fourth and fifth gain medium stages are doped fibers. Therefore, the second gain media 2200 include a plurality of gain media of different types.

The optical amplifier in the embodiments shown in FIG. 2 to FIG. 10 may further include a control circuit. The control circuit is configured to control an output optical signal of the optical amplifier. Specifically, at least one of the following of the output optical signal may be controlled: output optical power, a gain, a tilt, and the like. This is not limited in this application.

It may be clearly understood by a person skilled in the art that, for the purpose of convenient and brief description, for a detailed working process of the foregoing system, apparatus, and unit, refer to a corresponding process in the foregoing method embodiments, and details are not described herein again.

In the several embodiments provided in this application, it should be understood that the disclosed system, apparatus, and method may be implemented in other manners. For example, the described apparatus embodiments are merely examples. For example, the unit division is merely logical function division and may be other division in actual implementation. For example, a plurality of units or components may be combined or integrated into another system, or some features may be ignored or not performed. In addition, the displayed or discussed mutual couplings or direct couplings or communication connections may be implemented by using some interfaces. The indirect couplings or communication connections between the apparatuses or units may be implemented in electronic, mechanical, or other forms.

The units described as separate parts may or may not be physically separate, and parts displayed as units may or may not be physical units, may be located in one position, or may be distributed on a plurality of network units. Some or all of the units may be selected based on actual requirements to achieve the objectives of the solutions of embodiments.

In addition, functional units in embodiments of this application may be integrated into one processing unit, each of the units may exist alone physically, or two or more units are integrated into one unit. The integrated unit may be implemented in a form of hardware, or may be implemented in a form of a software functional unit.

When the integrated unit is implemented in the form of the software functional unit and sold or used as an independent product, the integrated unit may be stored in a computer-readable storage medium. Based on such an understanding, the technical solutions of this application essentially, or the part contributing to the prior art, or all or some of the technical solutions may be implemented in the form of a software product. The computer software product is stored in a storage medium and includes several instructions for instructing a computer device (which may be a personal computer, a server, or a network device) to perform all or some of the steps of the methods described in embodiments of this application. The foregoing storage medium includes any medium that can store program code, such as a USB flash drive, a removable hard disk, a read-only memory (read-only memory, ROM), a random access memory (random access memory, RAM), a magnetic disk, or an optical disc.

## Claims

1. An optical amplifier, comprising n gain medium stages sequentially arranged, wherein an optical signal is input to a first gain medium stage in the n gain medium stages and output from an n^{th} gain medium stage in the n gain medium stages, and the n gain medium stages are configured to sequentially amplify an input optical signal of the optical amplifier, wherein n≥2;
the n gain medium stages comprise a first gain medium and a second gain medium, wherein the first gain medium is an m^{th} gain medium stage in the n gain medium stages, the second gain medium is at least one gain medium subsequent to the first gain medium, wherein $m \leq \left⌈n/2\right⌉$, and the first gain medium and the second gain medium are gain media of different types;
an output end of the first gain medium is connected to an input end of the second gain medium; and
an average gain corresponding to a gain medium type of the first gain medium is greater than an average gain corresponding to a gain medium type of the second gain medium, wherein the average gain is an average of gains of a gain medium for signals in an operating band.

2. The optical amplifier according to claim 1, wherein a maximum average gain of the gain medium type of the first gain medium is greater than a maximum average gain of the gain medium type of the second gain medium; and
the maximum average gain is an average of gains of a gain medium at an optimal medium length for signals at various wavelengths in an operating band, and the optimal medium length is a medium length corresponding to a maximum gain at different medium lengths.

3. The optical amplifier according to claim 1 or 2, wherein m≥2, and the n gain medium stages sequentially arranged comprise a first gain medium stage to the m^{th} gain medium stage that are connected stage by stage; and
in the first gain medium stage to the m^{th} gain medium stage that are connected stage by stage, an average gain of a type of each gain medium stage is greater than an average gain of the type of the second gain medium.

4. The optical amplifier according to claim 3, wherein the first gain medium stage to the m^{th} gain medium stage that are connected stage by stage are gain media of a same type.

5. The optical amplifier according to any one of claims 1 to 4, wherein m≤n/3.

6. The optical amplifier according to claim 1, 2 or 5, wherein m=1; and
if a quantity of second gain media is 1, the output end of the first gain medium is connected to the input end of the second gain medium; or
if a quantity of second gain media is greater than 1, the output end of the first gain medium is connected to an input end of a foremost gain medium of the plurality of second gain media.

7. The optical amplifier according to claim 6, wherein in the n gain medium stages sequentially arranged, an average gain of a type of any gain medium is greater than an average gain of a type of a subsequent gain medium stage.

8. The optical amplifier according to any one of claims 1 to 5, wherein m≥2, and the n gain medium stages further comprise a third gain medium, the third gain medium is a k^{th} gain medium stage in the n gain medium stages, wherein k<m, and the third gain medium and the first gain medium are gain media of different types; and
an average gain of a gain medium type of the third gain medium is less than the average gain of the gain medium type of the first gain medium.

9. The optical amplifier according to any one of claims 1 to 8, wherein the n gain medium stages further comprise a fourth gain medium, an input end of the fourth gain medium is connected to an output end of the second gain medium, and the fourth gain medium and the second gain medium are gain media of different types; and
an average gain of a gain medium type of the fourth gain medium is greater than the average gain of the gain medium type of the second gain medium.

10. The optical amplifier according to any one of claims 1 to 9, wherein a target gain medium exists in at least one second gain medium, and gain flatness of the target gain medium is better than gain flatness of the first gain medium.

11. The optical amplifier according to claim 10, wherein gain flatness of a gain medium in the at least one second gain medium is better than the gain flatness of the first gain medium.

12. The optical amplifier according to claim 11, wherein in the n gain medium stages sequentially arranged, gain flatness of any gain medium is better than gain flatness of a preceding gain medium stage.

13. The optical amplifier according to any one of claims 1 to 12, wherein a plurality of second gain media are provided, and the plurality of second gain media comprise a plurality of gain media of different types.

14. The optical amplifier according to any one of claims 1 to 13, wherein the plurality of gain media of different types comprise at least one of the following:
doped fibers with different doping elements, doped fibers with different doping concentrations, and gain media with different structures.

15. The optical amplifier according to any one of claims 1 to 14, wherein a variable optical attenuator VOA and/or a gain flattening filter GFF are/is further comprised between the output end of the first gain medium and the input end of the second gain medium, wherein
the GFF is configured to balance gains of optical signals at various wavelengths, and the VOA is configured to adjust a gain point and a tilt of the optical amplifier.

16. An optical communication device, comprising the optical amplifier according to any one of claims 1 to 15.
